# EUROPÄISCHE PATENTSCHRIFT

(11) **EP 3 857 245 B1**
(45) Veröffentlichungstag und Bekanntmachung des Hinweises auf die Patenterteilung: **07.09.2022**
(21) Anmeldenummer: 19773824.8
(22) Anmeldetag: 24.09.2019
(51) Int. Cl.: G01R 31/42, G01R 31/28, G01R 19/165

(54) **VERFAHREN UND ANORDNUNG ZUM DURCHFÜHREN EINES ABSCHALTTESTS AN EINEM WECHSELRICHTER**
METHOD AND ARRANGEMENT FOR PERFORMING A SWITCH-OFF TEST IN AN INVERTER
PROCÉDÉ ET DISPOSITIF DE MISE EN OEUVRE D'UN ESSAI DE COUPURE SUR UN ONDULEUR

(30) Priorität: 28.09.2018 EP 18197403
(43) Veröffentlichungstag der Anmeldung: 04.08.2021
(73) Patentinhaber: FRONIUS INTERNATIONAL GmbH, 4643 Pettenbach (AT)
(72) Erfinder: DANMAYR, Joachim, 4643 Pettenbach (AT); KASBERGER, Christian, 4643 Pettenbach (AT)
(74) Vertreter: Patentanwälte Pinter & Weiss OG
(86) Internationale Anmeldenummer: PCT/EP2019/075724
(87) Internationale Veröffentlichungsnummer: WO 2020/064740

(56) Entgegenhaltungen:
- EP-A1- 2 662 697
- WO-A2-2014/075999
- US-A1- 2018 164 367

## Beschreibung

Die gegenständliche Erfindung betrifft ein Verfahren zum Durchführen eines Abschalttests an einem Wechselrichter, der einen Wechselstrom und eine Wechselspannung am Ausgang erzeugt. Die Erfindung betrifft auch eine Anordnung zum Durchführen eines Abschalttests an einem Wechselrichter, mit einer Steuereinheit, die eine Schaltanordnung des Wechselrichters zur Erzeugung eines Wechselstroms und einer Wechselspannung am Ausgang ansteuert.

Wechselrichter werden verwendet, um eine elektrische Energiequelle zur Netzeinspeisung mit einem elektrischen Versorgungsnetz zu verbinden. Im Fall bidirektionaler Wechselrichter auch, um einen elektrischen Energiespeicher aus der Energiequelle oder aus dem Versorgungsnetz zu laden. Im Fall von notstromfähigen Wechselrichtern kann dieser die gespeicherte Energie auch ohne Versorgungsnetz Verbrauchern zur Verfügung stellen. Die elektrische Energiequelle ist beispielsweise eine Photovoltaikanlage oder eine oder mehrere Photovoltaikzelle(n). Die elektrische Energiequelle kann aber auch eine Windkraftanlage, eine Batterie oder ähnliches sein. Solche an einem Versorgungsnetz angeschlossene Wechselrichter unterliegen strengen Reglementierungen, beispielsweise von den nationalen Netzbetreibern oder durch nationale Gesetzgebung. Für die Zulassung eines Wechselrichters für den Netzbetrieb muss ein solcher Wechselrichter verschiedene Prüfverfahren durchlaufen. Die US 2018/0164367 A1 beschreibt das Überprüfen des Abschaltens eines Wechselrichters, wenn der Wechselrichter vom Versorgungsnetz getrennt wird (Anti-Island Protection), wobei auch Abschaltzeitpunkte ermittelt werden.

Viele dieser Prüfungen zielen darauf ab, dass der Wechselrichter nach einer definierten maximalen Zeit nach dem Eintreten eines Fehlers den Einspeisebetrieb beenden muss und/oder sich selbst vom Versorgungsnetz trennen muss. Der Wechselrichter hat somit Überwachungsfunktionen implementiert, um verschiedene Fehlersignale zu detektieren und auszuwerten und gegebenenfalls den Wechselrichter vom Versorgungsnetz oder den Lasten zu trennen. Bei den durchzuführenden Zulassungsprüfungen wird ein Fehlersignal auf den Ausgang des Wechselrichters geschaltet, das vom Wechselrichter zu detektieren ist und es sind in der Regel die Abschaltzeitdauer und der Messwert, bei dem sich der Wechselrichter vom Versorgungsnetz getrennt hat oder den Einspeisebetrieb beendet hat, zu ermitteln. Damit soll die in der Prüfnorm festgeschriebene maximale Abschaltzeitdauer verifiziert werden. Ein Problem in diesem Zusammenhang ist festzustellen, zu welchem Zeitpunkt das Fehlersignal angelegt wurde, um die vom Anlegen bis zur Abschaltung vergangene Zeit genau bestimmen zu können.

Bisher wurde entweder vom Wechselrichter an einem Triggerausgang ein Triggersignal ausgegeben, sobald das Fehlersignal bereitgestellt wurde. Das Triggersignal konnte dann erfasst werden, um davon ausgehend die Abschaltzeitdauer zu erfassen. Der Triggerausgang ist jedoch nur intern zugänglich, da dieser Ausgang im normalen Betrieb nicht benötigt wird. Damit muss der Wechselrichter zum Abgreifen des Triggersignals geöffnet werden, was aufgrund der hohen Spannungen im Wechselrichter problematisch ist und ein Sicherheitsrisiko darstellt. Nachdem das Triggersignal sehr zeitkritisch ist, werden hierfür sehr hardwarenahe I/Os benötigt, die dann meistens mit gefährlichem Potential (Spannungen größer der Kleinschutzspannung von 50V) behaftet sind oder sich im Umfeld von gefährlichem Potential befinden, was ebenfalls problematisch bei der Durchführung von Abschalttests ist, weil entsprechende Sicherheitsvorkehrungen getroffen werden müssen. Zusätzlich muss dazu an der Hardware des Wechselrichters ein eigener Triggerausgang vorgesehen sein, was natürlich die Schaltung aufwendiger und teurer macht.

Eine andere bekannte Methode ist die Verwendung eines hoch auflösenden Oszilloskops, um die relevanten Signale aufzunehmen. Allerdings stellt es bei sehr kleinen Änderungen der Spannung oder des Stromes ein erhebliches Problem dar, aufgrund der Messauflösung einen korrekten Trigger zu setzen. Dazu musste man oftmals sehr hochwertige Oszilloskope verwenden, was die Prüfung wiederum teuer macht.

Es ist daher eine Aufgabe der Erfindung eine Anordnung und ein Verfahren anzugeben, mit denen für eine Abschaltprüfung an einem Wechselrichter ohne zusätzlichen Hardwareaufwand oder ohne zusätzliche teure Messmittel eine exakte Triggerung des Zeitpunktes des Fehlereintritts ermittelt werden kann, um eine einfache Ermittlung der Abschaltzeitdauer zu ermöglichen.

Diese Aufgabe wird erfindungsgemäß durch ein Verfahren nach Anspruch 1 und eine Anordnung nach Anspruch 5 gelöst.

Nach dem Start des Abschalttest zum ersten Zeitpunkt wird somit eine definierte Zeitdauer gewartet, bevor das Fehlersignal angelegt wird. Durch das Triggersignal kann der erste Zeitpunkt aber exakt und eindeutig bestimmt werden. Nachdem die Zeitdauer bekannt ist, kann auch eindeutig der zweite Zeitpunkt, an dem mit der Ausgabe des Fehlersignals begonnen wird, festgelegt werden. Der Abschaltzeitpunkt ist ebenfalls eindeutig als der Zeitpunkt feststellbar, an dem der Wechselstrom oder die Wechselspannung Null oder im Wesentlichen Null ist. Somit kann mit diesem Vorgehen die Abschaltzeitdauer, also die Zeit die zwischen dem Beginn des Fehlersignals und dem Abschalten vergeht, als Ergebnis des Abschalttests eindeutig und einfach ermittelt werden. Das Abschalten kann dabei beliebig erfolgen, beispielsweise durch das Öffnen von Trennstellen im Wechselrichter und/oder durch das Beenden des Erzeugens eines Wechselstromes / einer Wechselspannung. Das Abschalten kann auch beliebig ausgelöst werden, beispielsweise von der Steuereinheit des Wechselrichters.

Vorzugsweise wird der vom Wechselrichter erzeugte Wechselstrom oder die vom Wechselrichter erzeugte Wechselspannung gemessen und ausgewertet, um den ersten Zeitpunkt und/oder den Abschaltzeitpunkt zu ermitteln. Das erlaubt eine automatisierte Durchführung des Abschalttest, was den Abschalttest vereinfacht.

Eine weitere Vereinfachung, insbesondere der Ermittlung der verschiedenen Zeitpunkte, ergibt sich, wenn der erste Zeitpunkt und/oder der zweite Zeitpunkt auf einen Nulldurchgang des Wechselstromes oder der Wechselspannung synchronisiert werden.

In einer einfachen Ausgestaltung kann die Auswerteeinheit als Oszilloskop ausgeführt sein, das den Wechselstrom oder die Wechselspannung aufzeichnet, woraus der erste Zeitpunkt und/oder der Abschaltzeitpunkt ermittelbar sind.

Die gegenständliche Erfindung wird nachfolgend unter Bezugnahme auf die Figuren 1 bis 4 näher erläutert, die beispielhaft, schematisch und nicht einschränkend vorteilhafte Ausgestaltungen der Erfindung zeigen. Dabei zeigt
Fig.1 ein Ausführungsbeispiel eines Wechselrichters,
Fig.2 eine mögliche Anordnung zur Durchführung eines Abschalttests an einem Wechselrichter und
Fig.3 und 4 mögliche Ausführungen zum Triggern des Fehlersignals.

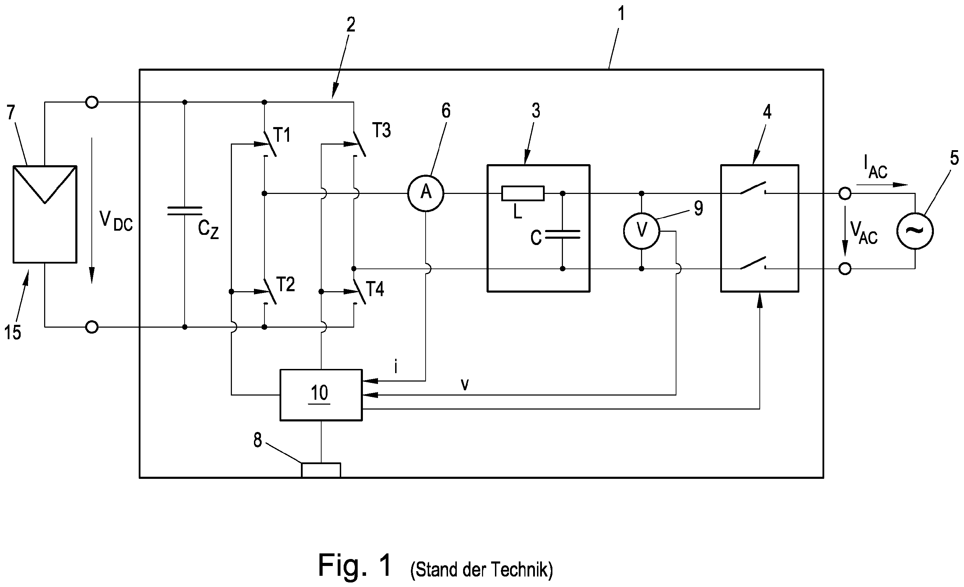

Fig.1 zeigt beispielhaft einen einphasigen Wechselrichter 1 mit einer Gleichspannungsseite mit Anschlussklemmen für eine Gleichspannung V_{DC} und einer Wechselspannungsseite mit Anschlussklemmen für eine Wechselspannung V_{AC}. An die Anschlussklemmen für eine Gleichspannung V_{DC} ist eine Gleichspannungsquelle als elektrische Energiequelle 15, beispielsweise zumindest ein Photovoltaikmodul 7, angeschlossen und über die Anschlussklemmen für eine Wechselspannung V_{AC} ist der Wechselrichter 1 mit einem elektrischen Versorgungsnetz 5, oder auch einer anderen elektrischen Last, verbunden.

Parallel zu den Anschlussklemmen für die Gleichspannung V_{DC} ist üblicherweise ein Gleichspannungszwischenkreiskondensator C_{Z} geschaltet, um die Gleichspannung V_{DC} zu glätten und zu stabilisieren. Wechselspannungsseitig kann vor den Anschlussklemmen für die Wechselspannung V_{AC} eine Trennstelle 4, beispielsweise mit Trennrelais, vorgesehen sein, um den Wechselrichter 1 vom Versorgungsnetz 5 trennen zu können. Vor der Trennstelle 4 kann ein Ausgangsfilter 3, beispielsweise mit einer Filterdrossel L und einer Filterkapazität C, geschaltet sein, um die erzeugte Wechselspannung V_{AC} zu glätten. Auch gleichspannungsseitig kann eine Trennstelle vorgesehen sein. Die Gleichspannungsseite des Wechselrichters 1 ist über eine Schaltanordnung 2, beispielsweise eine Brückenschaltung mit Halbleiterschalter T1, T2, T3, T4 mit der Wechselspannungsseite verbunden. Durch getaktetes Schalten der Halbleiterschalter T1, T2, T3, T4 der Schaltanordnung 2 wird in bekannter Weise die gewünschte Wechselspannung in Frequenz, Betrag und Phase erzeugt. Dabei synchronisiert sich der Wechselrichter 1 üblicherweise auf die Netzspannung im Versorgungsnetz 5.

Der Wechselrichter 1 kann auch mehrphasig ausgeführt sein, wobei die Schaltanordnung 2 und gegebenenfalls der Ausgangsfilter 3 und die Trennstelle 4 für jede Phase vorgesehen ist bzw. eine entsprechende Topologie der Schaltanordnung 2 verwendet wird.

Jeder Wechselrichter 1 hat auch eine Steuereinheit 10 (Hardware und Software) zum richtigen Ansteuern der Halbleiterschalter T1, T2, T3, T4 der Schaltanordnung 2. Die Steuereinheit 6 steuert auch die gleichspannungs- und/oder wechselspannungsseitige Trennstelle 4, um die Erzeugung der Wechselspannung V_{AC} oder analog des Wechselstroms I_{AC} zu beenden oder um den Wechselrichter 1 vom Versorgungsnetz 5 zu trennen. Der Wechselrichter 1 hat üblicherweise auch eine Ein-/Ausgabeschnittstelle 8, beispielsweise um Steuerbefehle von extern zu erhalten. Zur Steuerung des Wechselrichters 1 sind wechselspannungsseitig üblicherweise an geeigneter Stelle auch eine Spannungsmesseinheit 9 und eine Strommesseinheit 6 vorgesehen. Die erfassten Messgrößen werden in der Steuereinheit 10 zum Steuern des Wechselrichters 1 verarbeitet. Es kann auch gleichspannungsseitig eine Spannungsmesseinrichtung zum Messen der Zwischenkreisspannung vorgesehen sein, die ebenfalls in der Steuereinheit 10 verarbeitet werden kann.

Es sei aber angemerkt, dass es auch andere Topologien von Wechselrichtern 1 gibt, beispielsweise mit galvanischer Trennung der Gleichspannungsseite und der Wechselspannungsseite mittels eines Transformators oder mit einer anders ausgeführten Schaltanordnung 2, was aber für die gegenständliche Erfindung unerheblich ist. Das Ausführungsbeispiel nach Fig.1 dient lediglich der Erläuterung der Erfindung.

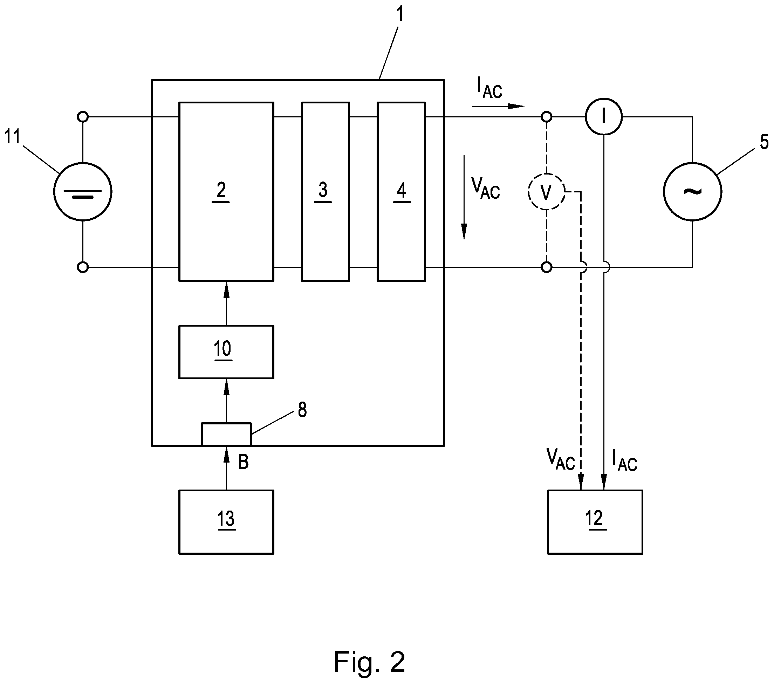

Zum Durchführen von Abschalttests am Wechselrichter 1 wird dieser üblicherweise im Laborumfeld von einer Gleichspannungsquelle 11 mit elektrischer Energie versorgt und an ein Versorgungsnetz 5, oder an eine andere elektrische Last, angeschlossen, wie in Fig.2 dargestellt. Ausgangsseitig wird der Wechselstrom I_{AC}, oder auch die Wechselspannung V_{AC} (wie strichliert angedeutet), messtechnisch erfasst und in einer Auswerteeinheit 12 (Hardware und/oder Software) ausgewertet. Von einer Prüfsteuereinheit 13 erhält der Wechselrichter 1 über die Ein-/Ausgabeschnittstelle 8 den Befehl B zur Durchführung eines Abschalttests. In welcher Art und Weise der Befehl B gegeben wird hängt natürlich von der Implementierung des Wechselrichter 1 und der Ein-/Ausgabeschnittstelle 8 ab, ist für die gegenständliche Erfindung jedoch unerheblich. Beispielsweise kann die Ein-/Ausgabeschnittstelle 8 als Busschnittstelle zu einem Datenkommunikationsbus, wie beispielsweise ein CAN-Bus oder Ethernet, implementiert sein. In diesem Fall wird der Befehl B beispielsweise als Busnachricht an den Wechselrichter 1 gesendet. Die Auswerteeinheit 12 und die Prüfsteuereinheit 13 können auch auf einer gemeinsamen Hardware ausgeführt sein. Es kann aber auch vorgesehen sein, dass ein Abschalttest direkt an der Ein-/Ausgabeschnittstelle 8, beispielsweise ein Touchscreen mit entsprechender Menüführung, auswählbar ist und der Befehl B direkt an der Ein-/Ausgabeschnittstelle 8, beispielsweise von einem Benutzer, gegeben wird. In diesem Fall kann auch vorgesehen sein, dass der Benutzer in das Menü für den Abschalttest nur durch vorherige Eingabe eines geheimen Sicherheitscodes oder Drücken einer geheimen Tastenkombination, oder ähnliches, gelangt, damit diese Funktionalität im normalen Betrieb nicht zugänglich ist.

Mit dem Befehl B kann auch die Art des Abschalttests übermittelt werden. Beispielsweise kann der Abschalttest zur Detektion eines Gleichanteils im Wechselstrom I_{AC} als Fehlersignal durchgeführt werden. Dabei kann mit dem Befehl auch der einzustellende Wert des Fehlersignals, beispielsweise der Wert des Gleichanteils, übermittelt werden. Andere typische Abschalttest sind Überspannung, Über-/Unterfrequenz, erkannte Inselnetze, Lichtbögen, etc. Das Fehlersignal, und der Wechselstrom I_{AC}, wird durch die Schaltanordnung 2 erzeugt, indem die Schaltanordnung 2 von der Steuereinheit 10 in geeigneter Weise angesteuert wird. Im Wechselrichter 1 ist eine Sicherheitsfunktion implementiert, vorzugsweise in der Steuereinheit 10 oder einer separaten Sicherheitseinheit, die den Wechselstrom I_{AC}, oder auch die Wechselspannung V_{AC}, auf mögliche Fehlersignale auswertet, beispielsweise anhand der im Wechselrichter 1 gemessenen Spannung v und/oder dem gemessenen Strom i. Wird ein Fehlersignal erkannt, muss sich der Wechselrichter 1 selbststätig vom Versorgungsnetz 5 trennen, beispielsweise über die Trennstelle 4 oder einer gleichspannungsseitigen Trennstelle, oder die Erzeugung der Wechselspannung V_{AC} / des Wechselstroms I_{AC} beenden.

In der Steuereinheit 10 ist eine Prüfroutine implementiert, beispielsweise als Software auf einer Steuereinheit-Hardware, die bei Erhalt des Befehls B gestartet wird. Die Prüfroutine erzeugt nun vor dem Erzeugen des Fehlersignals einen auf den Wechselstrom I_{AC}, oder die Wechselspannung V_{AC}, aufmoduliertes Triggersignal TS mit einer vorgegebenen Frequenz und Amplitude. Die Frequenz kann dabei maximal die halbe Taktfrequenz (typischerweise im Bereich größer 20kHz) der Schaltanordnung 2 betragen. Das Triggersignal TS soll dabei natürlich einfach und eindeutig identifizierbar sein und soll das Versorgungsnetz 5 möglichst wenig beeinflussen. Beispielsweise ist das Triggersignal TS ein Wechselsignal mit einer Frequenz im Bereich von der hundert- bis tausendfachen Netzfrequenz, beispielsweise eine Frequenz von 1kHz, mit einer Amplitude im Zehntelbereich der Amplitude des Wechseltroms I_{AC}, beispielsweise 0.3A-0.5 A, oder im Hunderstelbereich der Amplitude der Wechselspannung V_{AC}, beispielsweise 3V-10V bei 230V Netzspannung. Ein solches Triggersignal kann einfach im Wechselstrom I_{AC}, oder in der Wechselspannung V_{AC}, erkannt werden, sowohl durch Messen und Auswerten, aber auch auf einem einfachen Oszilloskop ohne besondere Anforderung an die Auflösung. Das Triggersignal TS ist dabei vorzugsweise auf den Wechselstrom I_{AC}, die Wechselspannung V_{AC}, synchronisiert, sodass das Triggersignal beispielsweise an einem Nulldurchgang des Wechselstroms I_{AC}, der Wechselspannung V_{AC}, beginnt und für eine bestimmte Periodendauer andauert, beispielsweise x Halbwellen des Wechselstroms I_{AC}, der Wechselspannung V_{AC}, mit x≥1. Das Triggersignal TS muss aber nicht zwingend synchronisiert sein, sondern kann grundsätzlich zu einer beliebigen Zeit beginnen und eine vorgegebene Zeit andauern.

Das Triggersignal TS wird durch entsprechendes Ansteuern der Schaltanordnung 2 durch die Steuereinheit 10 erzeugt und dient der Ankündigung des darauf folgenden Fehlersignals FS. Dabei kann die Zeitmessung bis zum Start des Fehlersignals FS vom Start des Triggersignals TS, als auch vom Ende des Triggersignals TS ausgehen. Wenn das Triggersignal TS eine definierte Dauer hat, dann wird vorzugsweise das Ende des Triggersignals TS als Trigger T für das Fehlersignal FS verwendet. Wenn das Triggersignal TS jedoch keine definierte Dauer hat, beispielsweise wenn als Triggersignal TS ein Puls ohne definiertem Ende auf die Wechselspannung V_{AC} geschaltet wird, dann wird vorzugsweise der Anfang des Triggersignals TS als Trigger T für das Fehlersignal FS verwendet und das Fehlersignal FS nach einer definierten Zeitdauer t_{D}≥0 nach dem Trigger T gestartet. Das Fehlersignal FS beginnt somit eine definierte Zeitdauer t_{D} nach dem Trigger T durch das Triggersignal TS. Beide Methoden sind aber natürlich gleichwertig.

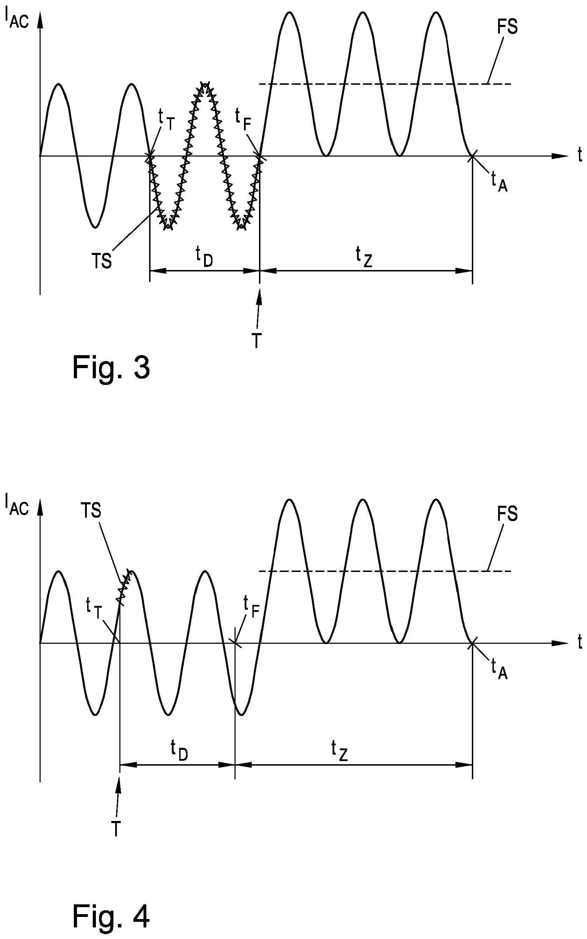

Das ist beispielhaft in Fig.3 am Beispiel des Wechselstromes I_{AC} (Wechselspannung V_{AC} ist natürlich analog) dargestellt. Bis zu einem Zeitpunkt t_{T} liegt der vom Wechselrichter 1 erzeugte Wechselstrom I_{AC} am Ausgang an, welcher in das Versorgungsnetz 5 eingespeist wird. Zum ersten Zeitpunkt t_{T} an einen Nulldurchgang des Wechselstroms I_{AC} wird dem Wechselstrom I_{AC} ein Triggersignal TS aufmoduliert, hier beispielsweise ein Wechselsignal mit 1kHz und 0.5A und einer vorgegebenen Zeitdauer t_{D} von drei Halbwellen. Der Trigger T für das Fehlersignal FS ist damit drei Halbwellen nach dem Zeitpunkt t_{T} zum zweiten Zeitpunkt t_{F} festgelegt. Das Fehlersignal FS, beispielsweise ein Gleichanteil im Wechselstrom I_{AC} (wie in Fig.3), oder z.B. auch eine Frequenzänderung, eine Amplitudenänderung oder eine Kombination daraus, beginnt damit zum definierten Zeitpunkt t_{F} (t_{T} + t_{D}).

Im Ausführungsbeispiel nach Fig.4 wird zum ersten Zeitpunkt t_{T} ein Puls auf den Wechselstrom I_{AC} aufmoduliert. Bis zum Zeitpunkt t_{T} liegt also der vom Wechselrichter 1 erzeugte Wechselstrom I_{AC} am Ausgang an, welcher in das Versorgungsnetz 5 eingespeist wird. Der detektierbare Beginn des Pulses zum Zeitpunkt t_{T} wird als Trigger T verwendet, wobei der Zeitpunkt t_{T} in diesem Beispiel nicht auf den Wechselstrom I_{AC} synchronisiert ist, sondern ein beliebiger Zeitpunkt ist. Nach einer definierten Zeitdauer t_{D} beginnt das Fehlersignal FS, beispielsweise ein Gleichanteil auf dem Wechselstrom I_{AC}, zum definierten zweiten Zeitpunkt t_{F} (t_{T} + t_{D}).

Mit Bezugnahme auf die Fig. 3 und 4 wird nun im Detail die Zeitmessung ab dem Zeitpunkt t_{F} beschrieben.

Demnach startet die Zeitmessung mit dem Fehlersignal FS zum Zeitpunkt t_{F} und endet zu einem Zeitpunkt t_{A}, an dem der Wechselrichter 1 vom Versorgungsnetz 5, oder der Last, getrennt wurde oder die Erzeugung des Wechselstromes I_{AC} / der Wechselspannung V_{AC} beendet wurde. Das Fehlersignal FS ist dabei ein Gleichanteil, womit beispielsweise ein Fehler eines Stromsensors im Wechselrichter 1 simuliert wird. Der Abschaltzeitpunkt t_{A}, an dem der Wechselrichter 1 am Ausgang vom Versorgungsnetz 5 getrennt wird, beispielsweise durch das Öffnen der Trennstelle 4, oder an dem die Erzeugung einer Wechselspannung V_{AC} / eines Wechselstrom I_{AC} beendet wird, beispielsweise durch die Steuereinheit 10, kann eindeutig festgestellt werden, indem ermittelt wird, ab wann der Wechselstrom I_{AC} / die Wechselspannung V_{AC} im Wesentlichen Null ist. Dabei kann geprüft werden, ob der Wechselstrom I_{AC} oder die Wechselspannung V_{AC} tatsächlich dauerhaft (um Nulldurchgänge zu unterscheiden) Null sind, oder dauerhaft innerhalb eines engen Fensters, beispielsweise ±0.3 A oder ±10 V um Null liegen. Die Zeitdifferenz zwischen dem Abschaltzeitpunkt t_{A} und dem Startpunkt des Fehlersignals t_{F} ergibt dann die mit dem Abschalttest zu prüfende Abschaltzeitdauer t_{Z} des Wechselrichters, welche mit der Auswerteeinheit 12 geprüft werden kann.

Die Zeitpunkte und Zeitdauern können durch Auswerten des mit der Auswerteeinheit 12 erfassten Wechselstroms I_{AC} / Wechselspannung V_{AC} ermittelt werden. Dazu kann der Wechselstrom I_{AC} oder die Wechselspannung V_{AC} wie in Fig.2 gemessen und in der Auswerteeinheit 12 ausgewertet werden. Die Auswerteeinheit 12 könnte aber auch als herkömmliches Oszilloskop ausgeführt sein, wobei keine Messeinheiten erforderlich wären, sondern der Wechselstrom I_{AC} / die Wechselspannung V_{AC} direkt abgegriffen werden könnten. Der Abschalttest kann durchgeführt werden, ohne den Wechselrichter 1 öffnen zu müssen, oder den Wechselrichter 1 hardwaremäßig anpassen zu müssen. Lediglich die Prüfroutine ist in der Steuereinheit 10 zu implementieren.

## Patentansprüche

1. Verfahren zum Durchführen eines Abschalttests an einem Wechselrichter (1), der einen Wechselstrom (I_{AC}) und eine Wechselspannung (V_{AC}) am Ausgang erzeugt, wobei zu einem ersten Zeitpunkt (t_{T}) ein Triggersignal (TS) auf den Wechselstrom (I_{AC}) oder die Wechselspannung (V_{AC}) aufmoduliert wird, an einem zweiten Zeitpunkt (t_{F}) eine definierte Zeitdauer (t_{D}) nach dem Beginn des Triggersignals (TS) zum ersten Zeitpunkt (t_{T}) mit dem Wechselrichter (1) ein Wechselstrom (I_{AC}) oder eine Wechselspannung (V_{AC}) mit einem Fehlersignal (FS) erzeugt wird, das vom Wechselrichter (1) erkannt wird und eine Abschaltung des Wechselrichters (1) auslöst, und der Abschaltzeitpunkt (t_{A}) des Wechselstroms (I_{AC}) oder der Wechselspannung (V_{AC}) ermittelt wird, woraus aus der Differenz zwischen dem Abschaltzeitpunkt (t_{A}) und dem zweiten Zeitpunkt (t_{F}) eine Abschaltzeitdauer (tz) des Wechselrichters (1) ermittelt wird.

2. Verfahren nach Anspruch 1, wobei
der vom Wechselrichter(1) erzeugte Wechselstrom (I_{AC}) oder die vom Wechselrichter (1) erzeugte Wechselspannung (V_{AC}) gemessen und ausgewertet wird, um den ersten Zeitpunkt (t_{T}) und/oder den Abschaltzeitpunkt (t_{A}) zu ermitteln.

3. Verfahren nach Anspruch 1 oder 2, wobei
der erste Zeitpunkt (t_{T}) auf einen Nulldurchgang des Wechselstromes (I_{AC}) oder der Wechselspannung (V_{AC}) synchronisiert wird.

4. Verfahren nach Anspruch 3, wobei
der zweite Zeitpunkt (t_{F}) auf einen Nulldurchgang des Wechselstromes (I_{AC}) oder der Wechselspannung (V_{AC}) synchronisiert wird.

5. Anordnung zum Durchführen eines Abschalttests an einem Wechselrichter (1) mit einer Steuereinheit (10), die dazu eingerichtet ist, eine Schaltanordnung (2) des Wechselrichters (1) zur Erzeugung eines Wechselstrom (I_{AC}) und einer Wechselspannung (VAC) am Ausgang anzusteuern, wobei
die Steuereinheit (10) eingerichtet ist, die Schaltanordnung (2) des Wechselrichters (1) an einem ersten Zeitpunkt (t_{T}) anzusteuern, um ein Triggersignal (TS) auf den Wechselstrom (I_{AC}) oder die Wechselspannung (V_{AC}) aufzumodulieren, wobei
die Steuereinheit (10) eingerichtet ist, die Schaltanordnung (2) des Wechselrichters (1) an einem zweiten Zeitpunkt (t_{F}), eine definierte Zeitdauer (t_{D}) nach dem Beginn des Triggersignals (TS) zum ersten Zeitpunkt (t_{T}), anzusteuern, um einen Wechselstrom (I_{AC}) oder eine Wechselspannung (V_{AC}) mit einem Fehlersignal (FS) zu erzeugen, wobei
im Wechselrichter (1) eine Sicherheitsfunktion implementiert ist, die eingerichtet ist, das Fehlersignal (FS) zu erkennen und eine Abschaltung des Wechselrichters (1) auszulösen, und wobei
eine Auswerteeinheit (12) vorgesehen ist, die eingerichtet ist, den Abschaltzeitpunkt (t_{A}) des Wechselstroms (I_{AC}) oder der Wechselspannung (V_{AC}) zu ermitteln, und aus der Differenz zwischen dem Abschaltzeitpunkt (t_{A}) und dem zweiten Zeitpunkt (t_{F}) eine Abschaltzeitdauer (tz) des Wechselrichters (1) zu ermitteln.

6. Anordnung nach Anspruch 5, wobei
eine Messeinrichtung vorgesehen ist, die zum Messen des vom Wechselrichter (1) erzeugten Wechselstromes (I_{AC}) oder der vom Wechselrichter (1) erzeugten Wechselspannung (V_{AC}) eingerichtet ist und die Auswerteeinheit (12) eingerichtet ist, den gemessenen Wechselstrom (I_{AC}) oder die gemessene Wechselspannung (V_{AC}) zur Ermittlung des ersten Zeitpunktes (t_{T}) und/oder des Abschaltzeitpunktes (t_{A}) auszuwerten.

7. Anordnung nach Anspruch 5 , wobei
die Auswerteeinheit (12) als Oszilloskop ausgeführt ist, das eingerichtet ist, den Wechselstrom (I_{AC}) oder die Wechselspannung (V_{AC}) aufzuzeichnen, um den ersten Zeitpunkt (t_{T}) und/oder den Abschaltzeitpunkt (t_{A}) zu ermitteln.

## Claims

1. Method for performing a shutdown test on an inverter (1) which generates an AC current (I_{AC}) and an AC voltage (V_{AC}) at the output, wherein a trigger signal (TS) is modulated to the AC current (I_{AC}) or the AC voltage (V_{AC}) at a first moment (t_{T}), at a second moment (t_{F}), which occurs a defined duration (t_{D}) after the start of the trigger signal (TS) at the first moment (t_{T}), an AC current (I_{AC}) or an AC voltage (V_{AC}) with a fault signal (FS) is generated with the inverter (1), which is detected by the inverter (1) and which triggers a shutdown of the inverter (1), and the shutdown moment (t_{A}) of the AC current (I_{AC}) or the AC voltage (V_{AC}) is determined, and a shutdown duration (t_{Z}) of the inverter (1) is determined from the difference between the shutdown moment (t_{A}) and the second moment (t_{F}).

2. Method according to claim 1, wherein the AC current (I_{AC}) generated by the inverter (1) or the AC voltage (V_{AC}) generated by the inverter (1) is measured and evaluated to determine the first moment (t_{T}) and/or the shutdown moment (t_{A}).

3. Method according to claim 1 or 2, wherein the first moment (t_{T}) is synchronized to a zero crossing of the AC current (I_{AC}) or the AC voltage (V_{AC}).

4. Method according to claim 3, wherein the second moment (t_{F}) is synchronized to a zero crossing of the AC current (I_{AC}) or the AC voltage (V_{AC}).

5. Arrangement for performing a shutdown test on an inverter (1), having a control unit (10) which is configured to control a switching arrangement (2) of the inverter (1) for generating an AC current (I_{AC}) and an AC voltage (VAC) at the output, wherein the control unit (10) is configured to control the switching arrangement (2) of the inverter (1) at a first moment (t_{T}) in order to modulate a trigger signal (TS) to the AC current (I_{AC}) or the AC voltage (V_{AC}), wherein the control unit (10) is configured to control the switching arrangement (2) of the inverter (1) at a second moment (t_{F}), which occurs a defined duration (t_{D}) after the start of the trigger signal (TS) at the first moment (t_{T}), for generating an AC current (I_{AC}) or an AC voltage (V_{AC}) with a fault signal (FS), wherein a safety function is implemented in the inverter (1), which is configured to detect the fault signal (FS) and to trigger a shutdown of the inverter (1), and wherein an evaluation unit (12) is provided which is configured to determine the shutdown moment (t_{A}) of the AC current (I_{AC}) or of the AC voltage (V_{AC}), and to determine a shutdown duration (t_{Z}) of the inverter (1) from the difference between the shutdown moment (t_{A}) and the second moment (t_{F}).

6. Arrangement according to claim 5, wherein a measuring device is provided which is configured for measuring the AC current (I_{AC}) generated by the inverter (1) or the AC voltage (V_{AC}) generated by the inverter (1), and the evaluation unit (12) is configured to evaluate the measured AC current (I_{AC}) or the measured AC voltage (V_{AC}) for determining the first moment (t_{T}) and/or the shutdown moment (t_{A}).

7. Arrangement according to claim 5, wherein the evaluation unit (12) is designed as an oscilloscope which is configured to record the AC current (I_{AC}) or the AC voltage (V_{AC}) in order to determine the first moment (t_{T}) and/or the shutdown moment (t_{A}).

## Revendications

1. Procédé de réalisation d'un essai de coupure sur un onduleur (1), lequel génère un courant alternatif (I_{AC}) et une tension alternative (V_{AC}) à la sortie, dans lequel à un premier moment (t_{T}), un signal de déclenchement (TS) est modulé sur le courant alternatif (I_{AC}) ou sur la tension alternative (V_{AC}), à un deuxième moment (t_{F}), une durée (t_{D}) définie après le début du signal de déclenchement (TS) au premier moment (t_{T}), un courant alternatif (I_{AC}) ou une tension alternative (V_{AC}) avec un signal d'erreur (FS) est généré(e) avec l'onduleur (1), lequel est reconnu par l'onduleur (1) et déclenche une coupure de l'onduleur (1), et le moment de coupure (t_{A}) du courant alternatif (I_{AC}) ou de la tension alternative (V_{AC}) est déterminé, sur la base de quoi une durée de coupure (tz) de l'onduleur (1) est déterminée à partir de la différence entre le moment de coupure (t_{A}) et le deuxième moment (t_{F}).

2. Procédé selon la revendication 1, dans lequel le courant alternatif (I_{AC}) généré par l'onduleur (1) ou la tension alternative (V_{AC}) générée par l'onduleur (1) est mesuré(e) et évalué(e), pour déterminer le premier moment (t_{T}) et/ou le moment de coupure (t_{A}).

3. Procédé selon la revendication 1 ou 2, dans lequel le premier moment (t_{T}) est synchronisé sur un passage par zéro du courant alternatif (I_{AC}) ou de la tension alternative (V_{AC}).

4. Procédé selon la revendication 3, dans lequel le deuxième moment (t_{F}) est synchronisé sur un passage par zéro du courant alternatif (I_{AC}) ou de la tension alternative (V_{AC}).

5. Dispositif pour la réalisation d'un essai de coupure sur un onduleur (1), comprenant une unité de commande (10), qui est conçue pour commander un dispositif de commutation (2) de l'onduleur (1) pour la génération d'un courant alternatif (I_{AC}) et d'une tension alternative (VAC) à la sortie, dans lequel l'unité de commande (10) est conçue pour commander le dispositif de commutation (2) de l'onduleur (1) à un premier moment (t_{T}), pour moduler un signal de déclenchement (TS) sur le courant alternatif (I_{AC}) ou sur la tension alternative (V_{AC}), dans lequel l'unité de commande (10) est conçue pour commander le dispositif de commutation (2) de l'onduleur (1) à un deuxième moment (t_{F}), une durée (t_{D}) définie après le début du signal de déclenchement (TS) au premier moment (t_{T}), pour la génération d'un courant alternatif (I_{AC}) ou d'une tension alternative (V_{AC}) avec un signal d'erreur (FS), dans lequel une fonction de sécurité est mise en œuvre dans l'onduleur (1), laquelle est conçue pour reconnaître le signal d'erreur (FS) et pour déclencher une coupure de l'onduleur (1), et dans lequel une unité d'évaluation (12) est prévue, laquelle est conçue pour déterminer le moment de coupure (t_{A}) du courant alternatif (I_{AC}) ou de la tension alternative (V_{AC}) et pour déterminer une durée de coupure (tz) de l'onduleur (1) à partir de la différence entre le moment de coupure (t_{A}) et le deuxième moment (t_{F}).

6. Dispositif selon la revendication 5, dans lequel un dispositif de mesure est prévu, lequel est conçu pour mesurer le courant alternatif (I_{AC}) généré par l'onduleur (1) ou la tension alternative (V_{AC}) générée par l'onduleur (1), et l'unité d'évaluation (12) est conçue pour évaluer le courant alternatif (I_{AC}) mesuré ou la tension alternative (V_{AC}) mesurée pour la détermination du premier moment (t_{T}) et/ou du moment de coupure (t_{A}).

7. Dispositif selon la revendication 5, dans lequel l'unité d'évaluation (12) est réalisée sous la forme d'un oscilloscope, lequel est conçu pour enregistrer le courant alternatif (I_{AC}) ou la tension alternative (V_{AC}), pour déterminer le premier moment (t_{T}) et/ou le moment de coupure (t_{A}).
